**Europäisches Patentamt**

**European Patent Office**

**Office européen des brevets**

(19)

(11) Numéro de publication : **0 509 915 B1**

(12) # FASCICULE DE BREVET EUROPEEN

(45) Date de publication du fascicule du brevet :
**31.05.95 Bulletin 95/22**

(51) Int. Cl.⁶ : **G01R 27/26**

(21) Numéro de dépôt : **92401054.9**

(22) Date de dépôt : **15.04.92**

(54) **Procédé et dispositif de mesure de condensateur.**

(30) Priorité : **18.04.91 FR 9104786**

(43) Date de publication de la demande :
**21.10.92 Bulletin 92/43**

(45) Mention de la délivrance du brevet :
**31.05.95 Bulletin 95/22**

(84) Etats contractants désignés :
**DE ES GB IT**

(56) Documents cités :
**DE-A- 3 413 849**
**DE-C- 717 345**
**US-A- 3 824 459**
**US-A- 3 886 447**

(73) Titulaire : **MARELLI AUTRONICA**
**19 Rue Lavoisier**
**F-92000 Nanterre (FR)**

(72) Inventeur : **Deschamps, Hervé**
**2 rue de Saint-Cloud**
**F-92150 Suresnes (FR)**

(74) Mandataire : **Schrimpf, Robert et al**
**Cabinet Regimbeau**
**26, Avenue Kléber**
**F-75116 Paris (FR)**

## Description

La présente invention concerne le domaine de la mesure de capacité de condensateurs.

La présente invention a pour but de proposer un nouveau procédé et un nouveau dispositif de mesure de condensateur, qui soit simple et fiable.

Ce but est atteint selon la présente invention, grâce à un procédé de mesure mettant en oeuvre deux condensateurs : un condensateur à mesurer, et un condensateur de référence de capacité connue, comprenant les étapes qui consistent à :

a) précharger à une valeur connue l'un, dit premier des deux condensateurs ayant une première électrode reliée à la masse,

b) placer une première électrode de l'autre, dit second, condensateur, au même potentiel que la seconde électrode du premier condensateur,

c) relier la première électrode du second condensateur à la seconde électrode du premier condensateur, et commuter le potentiel sur la seconde électrode du second condensateur, entre une première valeur connue et une seconde valeur connue,

d) comparer le potentiel sur la seconde électrode du premier condensateur avec une valeur de référence, réitérer les étapes b) et c) précitées tant que le potentiel sur la seconde électrode du premier condensateur, n'a pas franchi la valeur de référence, et compter le nombre de réitérations le potentiel sur la seconde électrode du second condensateur étant ramené de la seconde valeur connue à la première valeur connue après que la première électrode du second condensateur ait été séparée de la seconde électrode du premier condensateur, avant chaque itération.

Selon un autre mode de réalisation de la présente invention l'étape a) consiste à charger le premier condensateur sous une tension égale à ladite première valeur connue.

Selon un autre mode de réalisation de la présente invention, la valeur de référence est égale à ladite seconde valeur connue.

Selon un autre mode de réalisation de la présente invention, le procédé comprend en outre les étapes consistant à :

e) faire évoluer le potentiel sur la seconde électrode du second condensateur, par pas, de la seconde valeur connue vers la première valeur connue, jusqu'à détection d'un nouveau franchissement de la valeur de référence, par le potentiel sur la seconde électrode du premier condensateur, et compter le nombre de pas mis en oeuvre.

Selon un autre mode de réalisation de la présente invention, les étapes a), b), c), d) et e) précitées sont ensuite reproduites en permutant ladite première valeur connue et ladite seconde valeur connue.

Comme cela sera précisé sur la suite, cette dernière caractéristique permet d'éliminer la tension d'offset du comparateur.

Le dispositif de mesure conforme à la présente invention, destiné à la mise en oeuvre du procédé précité, comprend :

- des moyens de précharge aptes à précharger à une valeur connue, un premier condensateur ayant une première électrode reliée à la masse,

- des moyens de recopie de potentiel aptes à placer une première électrode d'un second condensateur, au même potentiel que la seconde électrode du premier condensateur,

- des moyens de transfert aptes à relier la première électrode du second condensateur à la seconde électrode du premier condensateur,

- des moyens de changement de potentiel, aptes à commuter le potentiel sur la seconde électrode du second condensateur, entre une première valeur connue et une seconde valeur connue,

- des moyens comparateurs, aptes à comparer le potentiel sur la seconde électrode du premier condensateur avec une valeur de référence,

- des moyens séquenceurs sensibles à la sortie des moyens comparateurs, et conçus pour piloter les moyens de recopie de potentiel, les moyens de transfert, et les moyens de changement de potentiel, et à compter le nombre de mises en oeuvre de ceux-ci.

Selon un autre mode de réalisation de la présente invention, les moyens de changement de potentiel sont conçus pour sélectivement faire évoluer le potentiel sur la seconde électrode du second condensateur, par pas, de la seconde valeur connue vers la première valeur connue.

D'autres caractéristiques, buts et avantages de la présente invention apparaîtront à la lecture de la description détaillée qui va suivre et en regard des dessins annexés donnés à titre d'exemple non limitatif et sur lesquels :

- la figure 1 représente schématiquement la structure d'un dispositif de mesure conforme à la présente invention,

- les figures 2, 3 et 4 représentent sous forme d'organigramme le procédé de mesure conforme à la présente invention, et

- les figures 5, 6 et 7 représentent les chronogrammes du fonctionnement du dispositif conforme à la présente invention.

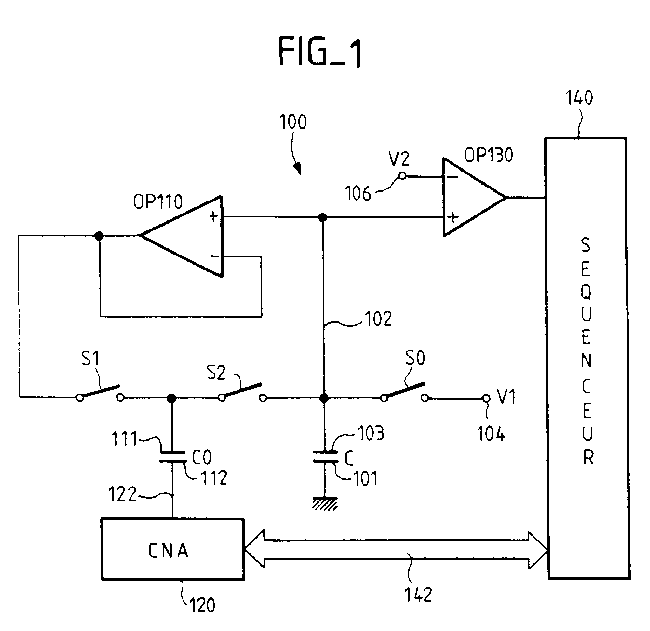

On va tout d'abord décrire la structure du dispositif de mesure 100 représenté sur la figure 1 annexée.

Sur cette figure, le condensateur à mesurer est référencé C.

Ce dispositif de mesure 100 comprend un condensateur de référence C0, trois interrupteurs S0, S1, S2, un amplificateur suiveur OP110, un convertisseur numérique/analogique 120, un comparateur OP130 et un séquenceur 140.

Le condensateur à mesurer C a une première électrode 101 reliée à la masse, et a une seconde électrode 103 reliée à une borne 102.

L'interrupteur S0 est connecté entre la borne 102 précitée et une borne d'alimentation positive 104 de potentiel V1. Ainsi lors de la fermeture de l'interrupteur S0, le condensateur C est chargé à la tension V1.

La borne 102 est également reliée à l'entrée non inverseuse de l'amplificateur opérationnel OP110. l'entrée inverseuse de l'amplificateur opérationnel OP110 est rebouclée sur sa sortie.

Le condensateur de référence C0 a une première électrode 111 reliée à la sortie de l'amplificateur opérationnel OP110, par l'intermédiaire de l'interrupteur S1, et a une seconde électrode reliée 112 à la sortie 122 du convertisseur 120.

Par ailleurs, la première électrode 111 du condensateur de référence C0 est reliée à la borne 102, c'est-à-dire à la seconde électrode 103 du condensateur C à mesurer, par l'intermédiaire de l'interrupteur S2.

La borne 102 est de plus reliée à l'entrée non inverseuse du comparateur OP130. L'entrée inverseuse de l'amplificateur opérationnel OP130 est reliée à une borne d'alimentation positive 106 de potentiel V2. Ainsi le comparateur OP130 compare le potentiel sur la borne 102, soit la tension aux bornes du condensateur C, avec le potentiel V2.

Le potentiel V2 de référence appliqué au comparateur OP130 est avantageusement supérieur au potentiel V1 présent sur la borne 104.

La sortie du comparateur OP130 est reliée au séquenceur 140.

Ce dernier pilote le convertisseur numérique/analogique 120 par l'intermédiaire du bus 142. Il pilote également la fermeture et l'ouverture des interrupteurs S0, S1, et S2 comme cela sera précisé par la suite.

Ainsi le séquenceur 140 contrôle la tension en sortie du convertisseur 120, c'est-à-dire la tension appliquée à la seconde électrode 112 du condensateur de référence C0.

La sortie 122 du convertisseur 120 peut être commutée par le séquenceur 140 entre deux valeurs E1 et E2. La tension E2 est supérieure à la tension E1.

De préférence, les tensions E1 et E2 obtenues en sortie du convertisseur 120 sont respectivement égales aux tensions de référence V1 et V2 appliquées aux bornes 104, 106.

De plus, la sortie 122 du convertisseur 120, dans un mode de fonctionnement contrôlé par le séquenceur 140 peut évoluer par pas entre les tensions E1 et E2. Le nombre de bits du bus 142 étant M, la valeur des pas précités est égale à $(E2 - E1)/(2^M - 1)$.

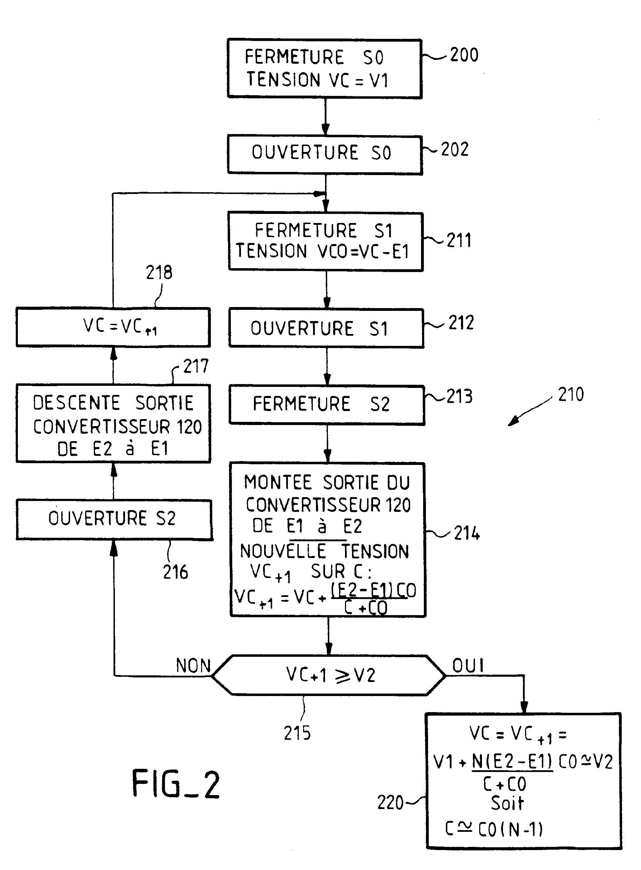

On va maintenant décrire le procédé de mesure conforme à la présente invention en regard des figures 2 à 7.

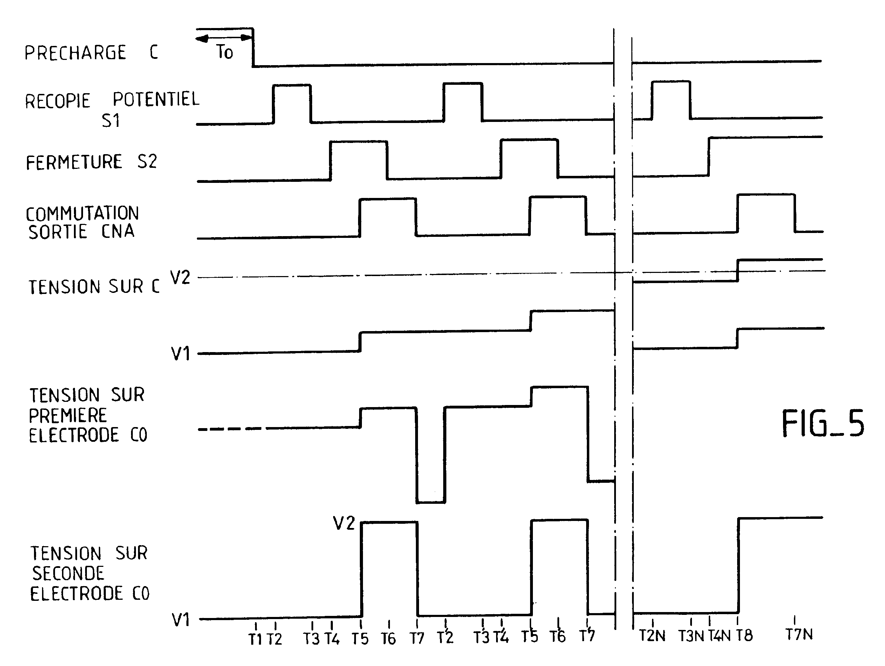

Dans un premier temps d'initialisation l'interrupteur S0 est fermé. Ce temps d'initialisation correspond à l'étape 200 sur la figure 2 et à la période T0 sur la figure 5. Ainsi, le condensateur à mesurer C est chargé à la tension V1. A la fin du temps d'initialisation T0, c'est-à-dire à l'instant T1 l'interrupteur S0 est ouvert. l'ouverture de l'interrupteur S0 correspond à l'étape 202 sur la figure 2.

Le système de mesure 100 opère alors une suite de cycles de mesure correspondant à la boucle d'itérations référencée 210 sur la figure 2. Chaque cycle de mesure 210 comprend successivement une phase de fermeture 211 puis d'ouverture 212 de l'interrupteur S1, puis une phase de fermeture 213 et d'ouverture 216 de l'interrupteur S2. Sur la figure 5, l'instant de fermeture de l'interrupteur S1 est référencé T2, l'instant d'ouverture de l'interrupteur S1 est référencé T3, l'instant de fermeture de l'interrupteur S2 est référencé T4, l'instant d'ouverture de l'interrupteur S2 est référencé T6.

De plus, pendant que l'interrupteur S2 est fermé, le séquenceur 140 fait passer la sortie 122 du convertisseur 120 d'une première tension E1 à une seconde tension supérieure E2.

Cette étape est référencée 214 sur la figure 2. Sur la figure 5, l'instant de passage de la tension E1 à la tension E2 en sortie du convertisseur est référencé T5.

Comme indiqué précédemment de préférence, la première tension E1 est égale à la tension V1 de la borne 104, tandis que la seconde tension E2 est égale à la tension V2 de la borne 106.

La première tension E1 est appliquée à la seconde électrode 112 du condensateur de référence C0 lors de la fermeture de l'interrupteur S1 entre les instants T2 et T3.

Lors de la fermeture de l'interrupteur S1, grâce à l'amplificateur suiveur OP110, la première électrode 111 du condensateur de référence C0 est placée au même potentiel que la seconde électrode 103 du condensateur C à mesurer.

Le séquenceur 140 peut faire passer la sortie 122 du convertisseur 120, de la première tension E1 à la seconde tension E2 soit après fermeture de l'interrupteur S2 comme représenté sur les figures annexées, soit avant. Toutefois, il est nécessaire que le séquenceur 140 ne fasse redescendre la sortie 122 du convertisseur 120 de la tension E2 à la tension E1 qu'après ouverture de l'interrupteur S2.

Sur la figure 2, l'étape de descente de la sortie 122 du convertisseur, de la tension E2 à la tension E1 est référencée 217. L'instant de descente est référencé T7 sur la figure 5.

Ainsi, à chaque cycle de mesure 210 la tension aux bornes du condensateur à mesurer C est incrémentée de la valeur suivante :

(1)    (E2 - E1) C0 / (C + C0).

De ce fait, après N cycles de mesure 210 la tension aux bornes du condensateur à mesurer C est incrémentée de :

(2)    N (E2 - E1) C0 / (C + C0).

La tension initiale aux bornes du condensateur étant V1, la tension aux bornes du condensateur à mesurer C, après les N cycles de mesure 210 est égale à :

(3)    V1 + [N (E2 - E1) C0] / (C + C0),

soit

(4)    E1 + [N (E2 - E1) C0] / (C + C0)

si E1 = V1.

Les cycles de mesure 210 précitées sont arrètés par le séquenceur 140 lorsque le comparateur OP130 bascule, c'est-à-dire lorsque la tension aux bornes du condensateur à mesurer C dépasse la tension de référence V2. Cet instant est référencé T8 sur la figure 5.

Par ailleurs, sur la figure 5, on a référencé T'2 à T'7, les instants du second cycle de mesure 210 respectivement homologues des instants T2 à T7 précités, et on a référencé T2N, T3N, T4N, et T7N les instants du Nième cycle de mesure 210 respectivement homologues des instants T2, T3, T4 et T7 précités.

L'étape de comparaison entre la tension aux bornes du condensateur C et la tension de référence V2 est référencée 215 sur la figure 2.

On déduit des relations précitées que :

(5)    V1 + [N (E2 - E1) C0] / (C + C0) ≃ V2,

soit

(6)    C ≃ C0 (N - 1).

Les étapes précitées du procédé sont représentées sur la figure 2, et le chronogramme correspondant sur la figure 5. Sur la figure 2, l'encadré 220 reprend les relations (5) et (6) ci-dessus tandis que l'étape 218 correspond à la fermeture de la boucle de réitération.

Toutefois, la relation (6) précitée est entachée d'une erreur du fait que lorsque le comparateur OP130 bascule la tension aux bornes du condensateur C dépasse la tension de référence V2 d'une valeur D, qui est au plus égale au pas des incréments de tension définis par la relation (1).

On a alors :

(7)    V1 + [N (E2 - E1) C0] / (C + C0) = V2 + D,

soit

si V1 = E1 et V2 = E2 :

(8)    E1 + [N (E2 - E1) C0] / (C + C0) = E2 + D.

Pour éliminer l'erreur due au dépassement D, le séquenceur 140 tout en maintenant alors l'interrupteur S2 fermé, commande progressivement la descente de la sortie 122 du convertisseur 120 du potentiel E2 vers le potentiel E1, par pas de :

(9)    (E2 - E1) C0 / (C + C0) (2^M - 1),

M représente le nombre de bits du convertisseur 120.

L'abaissement progressif de la tension de sortie du convertisseur 120 permet de mesurer la valeur du dépassement D précitée.

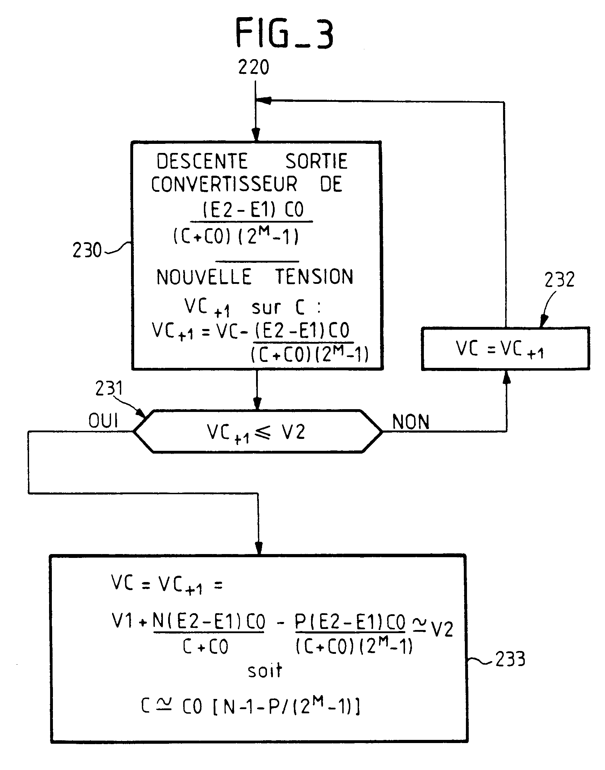

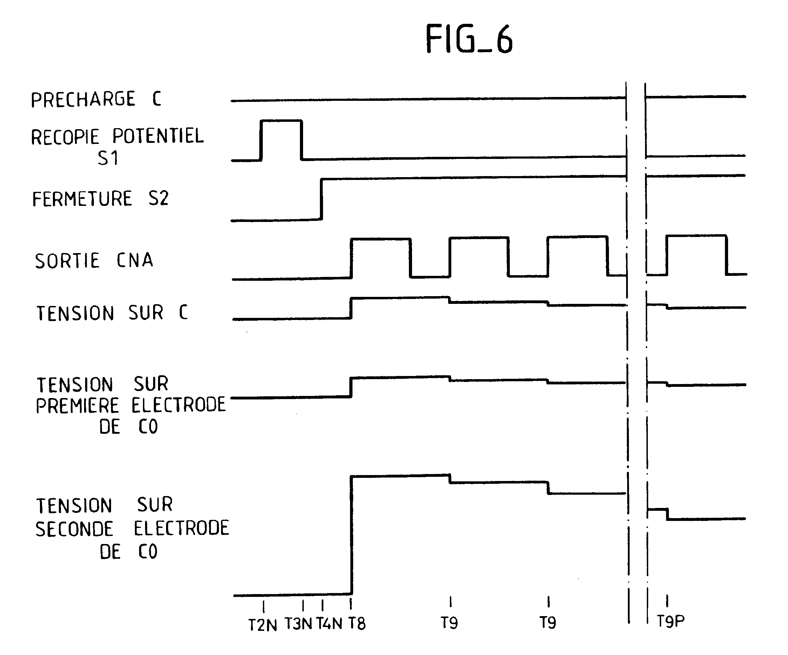

Les étapes successives de descente de la sortie 122 du convertisseur 120 sont référencées 230 sur la figure 3. Sur la figure 6, les instants de descente d'un pas de la sortie 122 du convertisseur 120 sont référencés T9. Le séquenceur 140 arrête l'évolution du convertisseur 120 après P décréments, lorsque le comparateur OP130 bascule à nouveau, c'est-à-dire lorsque la tension aux bornes du condensateur C repasse sous la tension de référence V2. Cet instant est référencé T9P sur la figure 6.

On a alors :

(10)    D = P (E2 - E1) C0 / (C + C0) (2^M - 1).

En associant les relations (8) et (10) on obtient :

(11)    E1 + [N (E2 - E1) C0] / (C + C0) = E2 + [P (E2 - E1) C0] / (C + C0) (2^M - 1),

soit :

(12)    C = C0 [N - 1 - P / (2^M - 1)].

Sur la figure 3, l'étape de comparaison de la tension aux bornes du condensateur C et de la tension de référence V2 est référencée 231. La réitération de la descente de la sortie 122 du convertisseur 120 est référencée 232. l'encadré 233 reprend les relations (11) et (12) ci-dessus.

la valeur du condensateur C est alors connue avec précision du fait que tous les paramètres de l'équation (12) sont connus :

N représente le nombre de cycles de mesure 210,

P représente le nombre de décréments en sortie du convertisseur, et

M représente le nombre de pas du convertisseur 120.

La valeur C donnée à l'équation (12) et résultant du procédé précédemment décrit peut être exploitée directement. Toutefois, la relation (12) ci-dessus est entachée également d'une erreur due à la tension d'offset V0 du comparateur OP130.

En raison de cette tension d'offset V0, la relation (8) doit en réalité s'écrire :

(13)    E1 + [N (E2 - E1) C0] / (C + C0) = E2 + D + V0.

Ce qui conduit, en combinant les relations (13) et (10) à :

(14)    E1 + [N (E2 - E1) C0] / (C + C0) = E2 + [P (E2 - E1) C0] / (C + C0) (2^M - 1) + V0,

soit

(15)    C = [(E2 - E1) / (E2 - E1 + V0)] C0 [N - 1 - P / (2^M - 1) - V0 / (E2 - E1)].

Pour éliminer cette erreur, la Demanderesse propose de réitérer les étapes antérieures en permutant les tensions de référence E1 et E2.

Cette nouvelle phase conduit à une relation (16) similaire, au signe près sauf pour la tension d'offset, à la relation (14) précitée, soit :

(16)    E2 + [Q (E1 - E2) C0] / (C + C0) = E1 + [R (E1 - E2) C0] / (C + C0) (2^M - 1) + V0.

En combinant les relations (14) et (16), on obtient

alors :

(17)     $[(N + Q) (E2 - E1) C0] / (C + C0) =$
$2 (E2 - E1) + [(P + R) (E2 - E1) C0] / (C +$
$C0) (2^M - 1)$.

La tension d'Offset V0 est ainsi éliminée et de (17) on déduit que :

(18)     $C = C0 [(N + Q) / 2 - 1 - (P + R) / 2$
$(2^M - 1)]$.

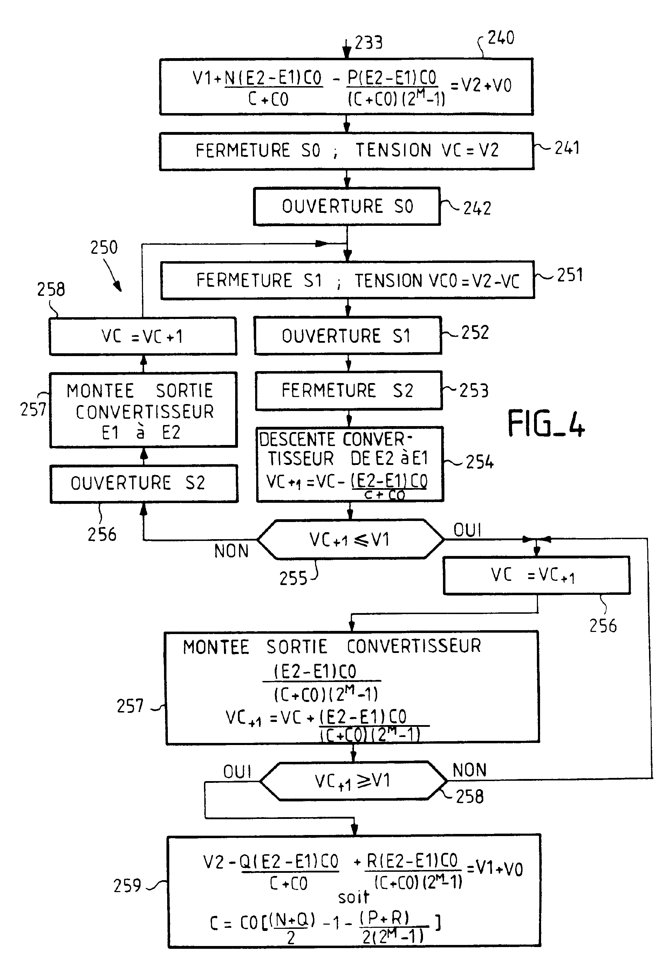

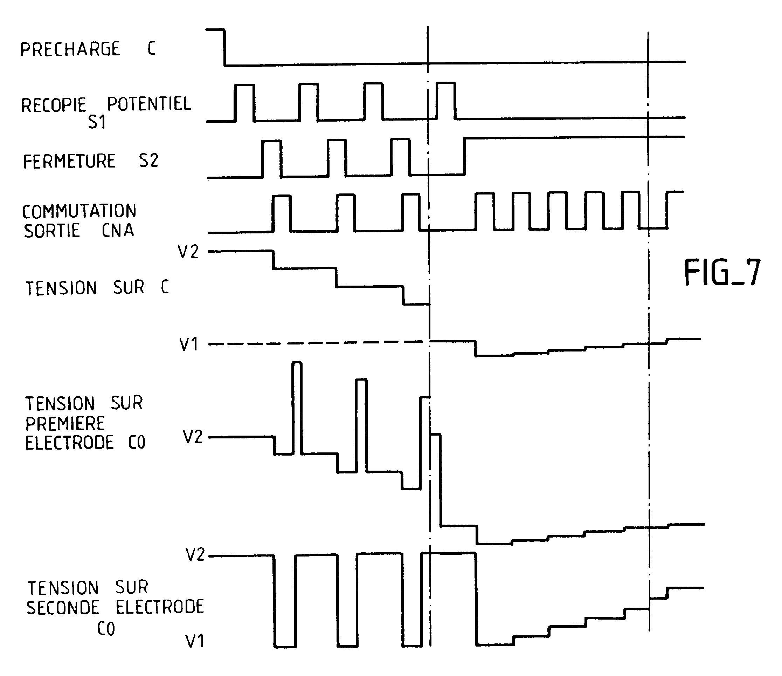

Cette nouvelle phase consistant à réitérer les étapes antérieures en permutant les tensions de référence E1 et E2 est illustrée par l'organigramme de la figure 4 et par le chronogramme de la figure 7.

Sur la figure 4 on a rappelé dans l'encadré 240 la relation (14).

Cette nouvelle phase comprend tout d'abord l'étape d'initialisation 241 de fermeture de l'interrupteur S0 pour relier la seconde électrode 103 du condensateur à mesurer C à la tension de référence V2, très préférentiellement égale à la tension E2. Le condensateur à mesurer C est ainsi préchargé sous une seconde valeur connue.

L'interrupteur S0 est ensuite ouvert à l'étape 242.

Puis le séquenceur 140 pilote des cycles d'itération 240 similaires aux cycles 210 précités.

Chaque cycle 250 comprend successivement :

- l'étape 251 de fermeture de l'interrupteur S1, afin de recopier sur la première électrode 111 du second condensateur C0, le potentiel V2 présent sur la seconde électrode 103 du condensateur à mesurer C ; au cours de cette étape 251, le potentiel présent sur la seconde électrode 112 du condensateur de référence C0 est égal à la tension E2,
- l'étape 252 d'ouverture de l'interrupteur S1,
- l'étape 253 de fermeture de l'interrupteur S2, pour autoriser le transfert de charges entre le condensateur de référence C0 et le condensateur à mesurer C,
- l'étape 254 consistant à commuter le potentiel E2 présent à la sortie 122 du convertisseur numérique/analogique 120, et donc présent sur la seconde électrode 112 du condensateur de référence C0, au potentiel E1,
- l'étape 255 consistant à comparer, à l'aide de l'amplificateur opérationnel OP130, la tension présente sur la seconde électrode 103 du condensateur à mesurer C avec la tension de référence V1 ; pour cela, bien entendu, le séquenceur 140 a préalablement remplacé le potentiel V2 antérieur par le potentiel V1 sur l'entrée inverseuse de l'amplificateur opérationnel OP130, tout comme il a préalablement remplacé le potentiel V1 antérieur par le potentiel V2 sur la borne 104,
- l'étape 256 consistant à ouvrir l'interrupteur S2, si l'étape 255 indique que le potentiel sur la seconde électrode 103 du condensateur à mesurer C reste supérieur à la tension V1,
- l'étape 257 consistant à commuter à nouveau la tension sur la sortie 122 du convertisseur 120 de la première tension E1 à la tension E2.

Sur la figure 4, l'étape 258 symbolise l'achèvement de l'itération 250.

A chaque itération 250, le potentiel sur le condensateur à mesurer C est réduit de :

(19)     $(E2 - E1) C0 / (C + C0)$

Par conséquent, à la fin des itérations 250, le potentiel aux bornes du condensateur C est égal à :

(20)     $V2 - Q (E2 - E1) C0 / (C + C0)$
relation dans laquelle Q représente le nombre d'itérations 250.

Le potentiel présent alors aux bornes du condensateur écarte de la valeur V1 d'une grandeur égale au plus au pas des variations de tension définies par la relation (19).

De façon similaire aux étapes antérieures, le séquenceur 140 peut faire passer la sortie 122 du convertisseur 120 de la tension E2 à la tension E1 soit après fermeture de l'interrupteur S2 comme représenté sur les figures annexées, soit avant. Toutefois, il est nécessaire que le séquenceur 140 ne fasse remonter la sortie 122 du convertisseur 120 de la tension E1 à la tension E2 (étape 257) qu'après ouverture de l'interrupteur S2 (étape 256).

Le séquenceur passe ensuite aux étapes 256 et 257 si, à l'étape 255, le comparateur OP130 constate que la tension aux bornes du condensateur à mesurer C est devenue inférieure à la tension de référence V1. l'étape 257 consiste à faire monter progressivement la sortie 122 du convertisseur 120 par pas égaux à ceux définis antérieurement par la relation (9).

Cette étape 257 est réitérée tant que l'étape ultérieure 258 indique que la tension aux bornes du condensateurs à mesurer C n'est pas redevenue supérieure à la tension de référence C1. Le nombre de réitérations de l'étape 257, indiqué R précédemment, est comptabilisé.

Lorsque l'étape 258 indique que la tension aux bornes du condensateur à mesurer C est redevenue supérieure à la tension de référence V1, on peut écrire les relations (16) et (18) précitées, qui sont reproduites dans l'encadré 259 de la figure 4.

Le séquenceur 140 est associé à des moyens de calcul aptes à déterminer la capacité du condensateur à mesurer C sur la base de l'une des relations (6), (12) ou (18).

Bien entendu, l'utilisation de l'équation (18) est référée dans la mesure où elle permet d'éliminer la tension d'offset du comparateur OP130 et fournit par conséquent un résultat précis.

Selon la description qui précède, le condensateur C à mesurer est préchargé et le condensateur de référence C0 est utilisé pour transférer des charges vers le condensateur C à mesurer.

On peut cependant prévoir d'inverser, dans le schéma de la figure 1, la position du condensateur à mesurer C et la position du condensateur de référence C0. Dans ce cas, le condensateur C0 de référence est préchargé et le condensateur C à mesurer est utilisé pour transférer des charges vers le condensateur C0 de référence. Bien entendu, il convient alors dans les relations (6), (12) et (18) précitées d'inverser les paramètres C et C0.

Bien entendu la présente invention n'est pas limitée au mode de réalisation particulier qui vient d'être décrit mais s'étend à toutes variantes conformes à son esprit.

La présente invention peut trouver application dans la mesure de tout type de condensateur. Elle peut en particulier, mais non exclusivement être utilisée pour la mesure de la capacité de sondes capacitives de niveau de liquide telle que décrite par exemple dans les documents FR-A-2234555, FR-A-2402193, FR-A-2451024, FR-A-2500169 et FR-A-2500337 ou encore dans les demandes de brevet français FR-A-2647898, FR-A-2647899 et FR-A-2647900.

Les sondes capacitives pour la mesure de niveau de liquide comprennent généralement plusieurs condensateurs, comme indiqué dans les documents ci-dessus. Dans ce cas, un multiplexeur analogique peut être placé entre ces différents condensateurs et le dispositif de mesure conforme à la présente invention, pour permettre à un tel dispositif unique de mesurer successivement les différents condensateurs.

**Revendications**

1. Procédé de mesure de la capacité d'un condensateur. mettant en oeuvre un condensateur de référence (C0) en plus du condensateur à mesurer (C), caractérisé par le fait qu'il comprend les étapes qui consistent à :
   a) à précharger à une valeur connue l'un, dit premier, des deux condensateurs (C) ayant une première électrode (101) reliée à la masse,
   b) placer un première électrode (111) de l'autre, dit second, condensateur (C0), au même potentiel que la seconde électrode (103) du premier condensateur (C),
   c) relier la première électrode (111) du second condensateur (C0) à la seconde électrode (103) du premier condensateur (C), et commuter le potentiel sur la seconde électrode (112) du second condensateur (C0), entre une première valeur connue (El) et une seconde valeur connue (E2),
   d) comparer le potentiel sur la seconde électrode (103) du premier condensateur (C) avec une valeur de référence (V2), réitérer les étapes b) et c) précitées tant que le potentiel sur la seconde électrode (103) du premier condensateur (C), n'a pas franchi la valeur de référence (V2), et compter le nombre de réitérations (N) le potentiel sur la seconde électrode (112) du second condensateur (C0) étant ramené de la seconde valeur connue (E2) à la première valeur connue (E1) après que la première électrode du second condensateur (C0) ait été séparée de la seconde électrode (103) du premier condensateur (C), avant chaque itération.

2. Procédé selon la revendication 1, caractérisé par le fait que l'étape a) consiste à charger le premier condensateur (C) sous une tension (V1) égale à ladite première valeur connue (E1).

3. Procédé selon l'une des revendications 1 ou 2, caractérisé par le fait que la valeur de référence (V2) est égale à ladite seconde valeur connue (E2).

4. Procédé selon l'une des revendications 1 à 3, caractérisé par le fait que ladite première valeur connue (El) est inférieure à ladite seconde valeur connue (E2).

5. Procédé selon l'une des revendications 1 à 4, caractérisé par le fait que l'étape b) consiste à relier la permière électrode (111) du second condensateur (C0) à la seconde électrode (103) du premier condensateur par l'intermédiaire d'un amplificateur suiveur (OP110) et d'un interrupteur (S1).

6. Procédé selon l'une des revendications 1 à 5, caractérisé par le fait que l'étape c) le potentiel sur la seconde électrode (112) du second condensateur (C0) est commuté de la première valeur connue (E1) à la seconde valeur connue (E2) après que la première électrode (111) du second condensateur (C0) ait été reliée à la seconde électrode (103) du premier condensateur.

7. Procédé selon l'une des revendications 1 à 5, caractérisé par le fait que l'étape c) le potentiel sur la seconde électrode (112) du second condensateur (C0) est commuté de la première valeur connue (E1) à la seconde valeur connue (E2) avant que la première électrode (111) du second condensateur (C0) ait été reliée à la seconde électrode (103) du premier condensateur.

8. Procédé selon l'une des revendications 1 à 7, caractérisé par le fait qu'après l'étape c) le potentiel sur la seconde électrode (112) du second condensateur (C0) est ramené de la seconde valeur connue (E2) à la première valeur connue (E1) après que la première électrode (111) du second condensateur (C0) ait été séparée de la seconde électrode (103) du premier condensateur (C).

9. Procédé selon l'une des revendications 1 à 7, caractérisé par le fait qu'il comprend en outre les étapes consistant à :
e) faire évoluer le potentiel sur la seconde électrode (112) du second condensateur (C0), par pas, de la seconde valeur connue (E2) vers la première valeur connue (E1), jusqu'à détection d'un nouveau franchissement de la valeur de référence (V2) par le potentiel sur la seconde électrode (103) du premier condensateur (C) et compter le nombre de pas (P) mis en oeuvre.

10. Procédé selon l'une des revendications 1 à 9, caractérisé par le fait que les étapes a), b), c), d) et e) précitées sont ensuite reproduites en permutant ladite première valeur connue (E1) et ladite seconde valeur connue (E2).

11. Procédé selon l'une des revendications 1 à 10, caractérisé par le fait qu'il comprend les étapes qui consistent à :
e) faire évoluer le potentiel sur la seconde électrode (112) du second condensateur (C0), par pas, de la seconde valeur connue (E2) vers la première valeur connue (E1), jusqu'à détection d'un nouveau franchissement de la valeur de référence (V2) par le potentiel sur la seconde électrode (103) du premier condensateur (C) et compter le nombre de pas (P) mis en oeuvre, au cours de cette étape e),
f) précharger à une seconde valeur connue le premier condensateur (C),
g) placer la première électrode (111) du second condensateur (C0) au même potentiel que la seconde électrode (103) du premier condensateur (C),
h) relier la première électrode (111) du second condensateur (C0) à la seconde électrode (103) du premier condensateur (C) et commuter le potentiel sur la seconde électrode (112) du second condensateur (C0) entre la seconde valeur connue (E2) et la première valeur connue (E1),
i) comparer le potentiel sur la seconde électrode (103) du premier condensateur (C) avec une seconde valeur de référence (V1), réitérer les étapes g) et h) précitées tant que le potentiel sur la seconde électrode (103) du premier condensateur (C) n'a pas franchi, la seconde valeur de reférence (V1) et compter le nombre (Q) de réitérations des étapes g) et h), le potentiel sur la seconde électrode (112) du second condensateur (C0) étant ramené de la première valeur connue (E1) à la seconde valeur connue (E2) après que la première électrode (111) du second condensateur (C0) ait été séparée de la seconde électrode (103) du premier condensateur (C), avant chaque réitération des étapes g) et h)
j) faire évoluer le potentiel sur la seconde électrode (112) du second condensateur (C0), par pas, de la première valeur connue (E1) vers la seconde valeur connue (E2), jusqu'à détection d'un nouveau franchissement de la seconde valeur de référence (V2) par le potentiel sur la seconde électrode (103) du premier condensateur (C), et compter le nombre de pas (R) mis en oeuvre, au cours de cette étape j).

12. Procédé selon la revendication 11, caractérisé par le fait que :
- l'étape a) consiste à charger le premier condensateur (C) sous une tension (V1) égale à la première valeur connue (E1),
- l'étape f) consiste à charger le premier condensateur (C) sous une tension (V2) égale à la seconde valeur connue (E2),
- la première valeur de référence est égale à la seconde valeur connue (E2), et
- la seconde valeur de référence est égale à la première valeur connue (E1).

13. Procédé selon l'une des revendications 1 à 12, caractérisé par le fait que le premier condensateur est le condensateur à mesurer (C).

14. Procédé selon l'une des revendications 1 à 8, prise en combinaison avec les revendications 2 et 3, caractérisé par le fait que la capacité du condensateur à mesurer est déterminée sur la base de la relation :
$$(6) \qquad C \simeq C0 \, (N - 1)$$
relation dans laquelle
C0 représente la capacité du condensateur de référence, et
N représente le nombre d'itérations des étapes b) et c).

15. Procédé selon l'une des revendications 1 à 9 prise en combinaison avec les revendications 2 et 3, caractérisé par le fait que la capacité du condensateur à mesurer est déterminée sur la base de la relation :
$$(12) \qquad C = C0 \, [N - 1 - P / (2^M - 1)]$$
relation dans laquelle
C0 représente la capacité du condensateur de référence,
N représente le nombre d'itérations des étapes b) et c),
P représente le nombre de pas mis en oeuvre à l'étape e), et
$(2^M - 1)$ représente le nombre de pas entre la première valeur connue (E1) et la seconde valeur connue (E2).

16. Procédé selon l'une des revendications 11 ou 12, prise en combinaison avec les revendications 2 et 3, caractérisé par le fait que le pas d'évolution à l'étape j) du potentiel sur la seconde électrode (112) du second condensateur (C0) étant égal au pas d'évolution du même potentiel à l'étape e), la capacité du condensateur à mesurer est déterminée sur la base de la relation :

   (18)    $C = C0 \, [(N + Q) / 2 - 1 - (P + R) / 2 \, (2^M - 1)]$

relation dans laquelle
C0 représente la capacité du condensateur de référence,
N représente le nombre d'itérations des étapes b) et c),
Q représente le nombre d'itérations des étapes g) et h),,
P représente le nombre de pas mis en oeuvre à l'étape e),
R représente le nombre de pas mis en oeuvre à l'étape j), et
$(2^M - 1)$ représente le nombre de pas entre la première valeur connue (E1) et la seconde valeur (E2).

17. Dispositif de mesure pour la mise en oeuvre du procédé conforme à l'une des revendications 1 à 16, caractérisé par le fait qu'il comprend :
   - des moyens (S0) de précharge aptes à précharger à une valeur connue (V1), un premier condensateur (C) ayant une première électrode (101) reliée à la masse,
   - des moyens (OP110, S1) de recopie de potentiel, aptes à placer une première électrode (111) d'un second condensateur (C0), au même potentiel que la seconde électrode (103), du premier condensateur (C)
   - des moyens (S2) de transfert aptes à relier la première électrode (111) du second condensateur (C0) à la seconde électrode (103) du premier condensateur (C),
   - des moyens (120) de changement de potentiel, aptes à commuter le potentiel sur la seconde électrode (112) du second condensateur (C0), entre une première valeur connue (E1) et une seconde valeur connue (E2),
   - des moyens comparateurs (OP130), aptes à comparer le potentiel sur la seconde électrode (103) du premier condensateur (C) avec une valeur de référence (V2),
   - des moyens séquenceurs (140) sensibles à la sortie des moyens comparateurs (OP130) et conçus pour piloter les moyens de recopie de potentiel (OP110, S1), les moyens de transfert (S2), et les moyens de changement de potentiel (120), et à compter le nombre (N, P, Q, R) de mises en oeuvre de ceux-ci.

18. Dispositif selon la revendication 17, caractérisé par le fait que les moyens de changement de potentiel (120) sont conçus pour sélectivement faire évoluer le potentiel sur la seconde électrode (112) du second condensateur (C0), par pas, de la seconde valeur (E2) connue vers la première valeur connue (E1).

19. Dispositif selon l'une des revendications 17 et 18, caractérisé par le fait que les moyens de changement de potentiel (120) sont conçus en outre pour sélectivement commuter le potentiel sur la seconde électrode (112) du second condensateur (C0) entre la seconde valeur connue (E2) et la première valeur connue (E1), puis pour faire évoluer le potentiel sur la seconde électrode (112) du second condensateur (C0), par pas, de la première valeur connue (E1) vers la seconde valeur connue (E2).

20. Dispositif selon l'une des revendications 17 à 19, caractérisé par le fait que les moyens (S0) de précharge comprennent un interrupteur.

21. Dispositif selon la revendication 20, caractérisé par le fait que l'interrupteur de précharge (S0) est conçu pour relier la seconde électrode (103) du premier condensateur (C) soit à un potentiel égal à la première valeur connue (E1), soit à un potentiel égal à la seconde valeur connue (E2).

22. Dispositif selon l'une des revendications 17 à 21, caractérisé par le fait que les moyens de recopie de potentiel comprennent un amplificateur opérationnel suiveur (OP110) et un interrupteur (S1).

23. Dispositif selon l'une des revendications 17 à 22, caractérisé par le fait que les moyens de transfert comprennent un interrupteur (S2).

24. Dispositif selon l'une des revendications 17 à 23, caractérisé par le fait que les moyens de changement de potentiel (120) comprennent un convertisseur numérique/analogique piloté par les moyens séquenceurs (140).

25. Dispositif selon l'une des revendications 17 à 24, caractérisé par le fait que la dite valeur connue étant égale à la première valeur connue et la valeur de référence étant égale à la seconde valeur connue; et qu'il comprend des moyens aptes à déterminer la capacité du condensateur à mesurer (C) sur la base de la relation :

(6)      $C \simeq C0 \, (N - 1)$

relation dans laquelle

C0 représente la capacité du condensateur de référence, et

N représente le nombre d'itérations des étapes b) et c).

26. Dispositif selon l'une des revendications 17 à 2u, caractérisé par le fait que la dite valeur connue étant égale à la première valeur connue et la valeur de référence étant égale à la seconde valeur connue, et qu'il comprend des moyens aptes à mesurer la capacité du condensateur à mesurer (C) sur la base de la relation :

(12)      $C = C0 \, [N - 1 - P / (2^M - 1)]$

relation dans laquelle

C0 représente la capacité du condensateur de référence,

N représente le nombre d'itérations des étapes b) et c),

P représente le nombre de pas mis en oeuvre à l'étape e), et

$(2^M - 1)$ représente le nombre de pas entre la première valeur connue (E1) et la seconde valeur connue (E2).

27. Dispositif selon l'une des revendications 17 à 24, caractérisé par le fait que la dite valeur connue étant égale à la première valeur connue et la valeur de référence étant égale à la seconde valeur connue, et qu'il comprend des moyens aptes à mesurer la capacité du condensateur à mesurer sur la base de la relation :

(18)      $C = C0 \, [(N + Q) / 2 - 1 - (P + R) / 2 \, (2^M - 1)]$

relation dans laquelle

C0 représente la capacité du condensateur de référence,

N représente le nombre d'itérations des étapes b) et c),

Q représente le nombre d'itérations des étapes g) et h),,

P représente le nmbre de pas mis en oeuvre à l'étape e),

R représente le nombre de pas mis en oeuvre à l'étape j), et

$(2^M - 1)$ représente le nombre de pas entre la première valeur connue (E1) et la seconde valeur (E2).

28. Dispositif selon la revendication 24 prise en combinaison avec l'une des revendications 26 et 27, caractérisé par le fait que M représente le nombre de bits du convertisseur numérique/analogique (120).

**Patentansprüche**

1. Verfahren zum Messen der Kapazität eines Kondensators unter Verwendung eines Bezugskondensators (C0) zuzüglich zum zu messenden Kondensator (C), dadurch gekennzeichnet, daß es die Schritte umfaßt, die darin bestehen, daß
   a) ein erster der beiden Kondensatoren (C), der eine erste Elektrode (101) aufweist, die an Masse liegt, auf einen bekannten Wert vorgeladen wird,
   b) eine erste Elektrode (111) des anderen, zweiten Kondensators (C0) auf das gleiche Potential wie dem der zweiten Elektrode (103) des ersten Kondensators (C) gebracht wird,
   c) die erste Elektrode (111) des zweiten Kondensators (C0) mit der zweiten Elektrode (103) des ersten Kondensators (C) verbunden und das Potential an der zweiten Elektrode (112) des zweiten Kondensators (C0) zwischen einem ersten bekannten Wert (E1) und einem zweiten bekannten Wert (E2) umgeschaltet wird,
   d) das Potential an der zweiten Elektrode (103) des ersten Kondensators (C) mit einem Bezugswert (V2) verglichen wird, die vorgenannten Schritte b) und c) wiederholt werden, bis das Potential an der zweiten Elektrode (103) des ersten Kondensators (C) den Bezugswert (V2) nicht mehr überschreitet, und die Anzahl der Wiederholungen (N) gezählt wird, wobei vor jeder Wiederholung das Potential an der zweiten Elektrode (112) des zweiten Kondensators (C0) vom zweiten bekannten Wert (E2) auf den ersten bekannten Wert (E1) zurückgeführt wird, nachdem die erste Elektrode des zweiten Kondensators (C0) von der zweiten Elektrode (103) des ersten Kondensators (C) abgetrennt wurde.

2. Verfahren nach Anspruch 1, dadurch gekennzeichnet, daß der Schritt a) darin besteht, daß der erste Kondensator (C) unter einer Spannung (V1) aufgeladen wird, die gleich dem genannten ersten bekannten Wert (E1) ist.

3. Verfahren nach einem der Ansprüche 1 oder 2, dadurch gekennzeichnet, daß der Bezugswert (V2) gleich dem genannten zweiten bekannten Wert (E2) ist.

4. Verfahren nach einem der Ansprüche 1 bis 3, dadurch gekennzeichnet, daß der genannte erste bekannte Wert (E1) kleiner als der genannte zweite bekannte Wert (E2) ist.

5. Verfahren nach einem der Ansprüche 1 bis 4, dadurch gekennzeichnet, daß der Schritt b) darin besteht, daß die erste Elektrode (111) des zweiten Kondensators (C0) mit der zweiten Elektrode (103) des ersten Kondensators über einen zwischengeschalteten Folgeverstärker (OP110) und einen Schalter (S1) verbunden wird.

6. Verfahren nach einem der Ansprüche 1 bis 5, dadurch gekennzeichnet, daß im Schritt c) das Potential an der zweiten Elektrode (112) des zweiten Kondensators (C0) vom ersten bekannten Wert (E1) auf den zweiten bekannten Wert (E2) umgeschaltet wird, nachdem die erste Elektrode (111) des zweiten Kondensators (C0) mit der zweiten Elektrode (103) des ersten Kondensators verbunden ist.

7. Verfahren nach einem der Ansprüche 1 bis 5, dadurch gekennzeichnet, daß im Schritt c) das Potential an der zweiten Elektrode (112) des zweiten Kondensators (C0) vom ersten bekannten Wert (E1) auf den zweiten bekannten Wert (E2) umgeschaltet wird, bevor die erste Elektrode (111) des zweiten Kondensators (C0) mit der zweiten Elektrode (103) des ersten Kondensators verbunden wird.

8. Verfahren nach einem der Ansprüche 1 bis 7, dadurch gekennzeichnet, daß nach dem Schritt c) das Potential der zweiten Elektrode (112) des zweiten Kondensators (C0) vom zweiten bekannten Wert (E2) auf den ersten bekannten Wert (E1) zurückgeführt wird, nachdem die erste Elektrode (111) des zweiten Kondensators (C0) von der zweiten Elektrode (103) des ersten Kondensators (C) abgetrennt ist.

9. Verfahren nach einem der Ansprüche 1 bis 7, dadurch gekennzeichnet, daß es weitere Schritte umfaßt, die darin bestehen daß,

   e) das Potential der zweiten Elektrode (112) des zweiten Kondensators (C0) schrittweise vom zweiten bekannten Wert (E2) zum ersten bekannten Wert (El) wandern gelassen wird, bis ein erneutes Überschreiten des Bezugswertes (V2) durch das Potential an der zweiten Elektrode (103) des ersten Kondensators (C) festgestellt wird, und die Anzahl der ausgeführten Schritte (P) gezählt wird.

10. Verfahren nach einem der Ansprüche 1 bis 9, dadurch gekennzeichnet, daß die genannten Schritte a) b) c) d) und e) danach bei geänderten ersten und zweiten bekannten Werten (E1, E2) wiederholt werden.

11. Verfahren nach einem der Ansprüche 1 bis 10, dadurch gekennzeichnet, daß es Schritte umfaßt, die darin bestehen, daß

e) das Potential an der zweiten Elektrode (112) des zweiten Kondensators (C0) schrittweise vom zweiten bekannten Wert (E2) in Richtung auf den ersten bekannten Wert (E1) wandern gelassen wird, bis ein erneutes Überschreiten des Bezugswertes (V2) durch das Potential an der zweiten Elektrode (103) des ersten Kondensators (C) festgestellt wird, und die Anzahl der ausgeführten Schritte (P) im Verlauf dieses Schrittes e) gezählt wird,
f) der erste Kondensator (C) auf einen zweiten bekannten Wert vorgeladen wird,
g) die erste Elektrode (111) des zweiten Kondensators (C0) auf dasselbe Potential wie dem der zweiten Elektrode (103) des ersten Kondensators (C) gebracht wird,
h) die erste Elektrode (111) des zweiten Kondensators (C0) mit der zweiten Elektrode (103) des ersten Kondensators (C) verbunden und das Potential an der zweiten Elektrode (112) des zweiten Kondensators (C0) zwischen dem zweiten bekannten Wert (E2) und dem ersten bekannten Wert (E1) umgeschaltet wird,
i) das Potential an der zweiten Elektrode (103) des ersten Kondensators (C) mit einem zweiten Bezugswert (V1) verglichen wird, die genannten Schritte g) und h) wiederholt werden, bis das Potential an der zweiten Elektrode (103) des ersten Kondensators (C) den zweiten Bezugswert (V1) nicht mehr überschreitet, und die Anzahl (Q) der Wiederholungen der Schritte g) und h) gezählt wird, vor jeder Wiederholung der Schritte g) und h) das Potential an der zweiten Elektrode (112) des zweiten Kondensators (C0) vom ersten bekannten Wert (E1) auf den zweiten bekannten Wert (E2) zurückgeführt wird, nachdem die erste Elektrode (111) des zweiten Kondensators (C0) von der zweiten Elektrode (103) des ersten Kondensators (C) abgetrennt ist,
j) das Potential an der zweiten Elektrode (112) des zweiten Kondensators (C0) schrittweise vom ersten bekannten Wert (E1) in Richtung auf den zweiten bekannten Wert (E2) wandern gelassen wird, bis ein erneutes Überschreiten des zweiten Bezugswertes (V2) durch das Potential an der zweiten Elektrode (103) des ersten Kondensators (C) festgestellt wird, und die Anzahl (R) der im Verlauf des Schritts j) ausgeführten Schritte gezählt wird.

12. Verfahren nach Anspruch 11, dadurch gekennzeichnet, daß

   - der Schritt a) darin besteht, daß der erste Kondensator (C) unter einer Spannung (V1) aufgeladen wird, die gleich dem ersten bekannten Wert (E1) ist,
- der Schritt f) darin besteht, daß der erste Kondensator (C) unter einer Spannung (V2) aufgeladen wird, die gleich dem zweiten bekannten Wert (E2) ist,
- der erste Bezugswert gleich dem zweiten bekannten Wert (E2) ist und
- der zweite Bezugswert gleich dem ersten bekannten Wert (E1) ist.

13. Verfahren nach einem der Ansprüche 1 bis 12, dadurch gekennzeichnet, daß der erste Kondensator der zu messende Kondensator (C) ist.

14. Verfahren nach einem der Ansprüche 1 bis 8, in Kombination mit den Ansprüchen 2 und 3, dadurch gekennzeichnet, daß die Kapazität des zu messenden Kondensators auf der Grundlage der Beziehung

$$(6) \qquad C \simeq C0\,(N - 1)$$

bestimmt wird, in welcher Beziehung
C0 die Kapazität des Bezugskondensators bezeichnet und N die Anzahl der Wiederholungen der Schritte b) und c) ist.

15. Verfahren nach einem der Ansprüche 1 bis 9 in Kombination mit den Ansprüchen 2 und 3, dadurch gekennzeichnet, daß die Kapazität des zu messenden Kondensators auf der Grundlage der folgenden Beziehung

$$(12) \qquad C = C0\,[N - 1 - P / (2^M - 1)]$$

bestimmt wird, in welcher Beziehung
C0 die Kapazität des Bezugskondensators wiedergibt,
N die Anzahl der Wiederholungen der Schritte b) und c) wiedergibt,
P die Anzahl der im Schritt e) ausgeführten Schritte bezeichnet und
$(2^M - 1)$ die Anzahl der Schritte zwischen dem ersten bekannten Wert (E1) und dem zweiten bekannten Wert (E2) bezeichnet.

16. Verfahren nach einem der Ansprüche 11 oder 12, in Kombination mit den Ansprüchen 2 oder 3, dadurch gekennzeichnet, daß der Schritt des Wanderns des Potentials an der zweiten Elektrode (112) des zweiten Kondensators (C0) im Schritt j) gleich einem Schritt des Wanderns des gleichen Potentials im Schritt e) ist, die Kapazität des zu messenden Kondensators auf der Grundlage der Beziehung:

$$(18) \qquad C = C0\,[\,(N + Q) / 2 - 1 - (P + R) / 2\,(2^M - 1)]$$

bestimmt wird,
in welcher Beziehung C0 die Kapazität des Bezugskondensators bezeichnet,
N die Anzahl der Wiederholungen der Schritte b) und c) ist,

Q die Anzahl der Wiederholungen der Schritte g) und h) bezeichnet,
P die Anzahl der im Schritt e) ausgeführten Schritte wiedergibt,
R die Anzahl der im Schritt j) ausgeführten Schritte wiedergibt und
$(2^M - 1)$ die Anzahl der Schritte zwischen dem ersten bekannten Wert (E1) und dem zweiten bekannten Wert (E2) bezeichnet.

17. Messvorrichtung zur Durchführung des Verfahrens nach einem der Ansprüche 1 bis 16, dadurch gekennzeichnet, daß sie
- Vorladeeinrichtungen (S0), die einen ersten Kondensator (C), der eine erste Elektrode (101) aufweist, die an Masse liegt, auf einen bekannten Wert (V1) aufladen können,
- Potentialkopiereinrichtungen (OP110, S1), die eine erste Elektrode (111) eines zweiten Kondensators (C0) auf das gleiche Potential wie dem der zweiten Elektrode (103) des ersten Kondensators (C) bringen können,
- Schalteinrichtungen (S2), die die erste Elektrode (111) des zweiten Kondensators (C0) mit der zweiten Elektrode (103) des ersten Kondensators (C) verbinden können,
- Potentialänderungseinrichtungen (120) die das Potential an der zweiten Elektrode (112) des zweiten Kondensators (C0) zwischen einem ersten bekannten Wert (E1) und einem zweiten bekannten Wert (E2) ändern können,
- Komparatoreinrichtung (OP130), die das Potential an der zweiten Elektrode (103) des ersten Kondensators (C) mit einem Bezugswert (V2) vergleichen können,
- Folgesteuereinrichtungen (140) umfaßt, die auf das Ausgangssignal der Komparatoreinrichtungen (OP130) ansprechen und so ausgebildet sind, daß sie die Potentialkopiereinrichtungen (OP110), (S1), die Schalteinrichtungen (S2) und die Potentialänderungseinrichtungen (120) ansteuern und die Anzahl (N,P,Q,R) zählen, in der dieses erfolgt.

18. Vorrichtung nach Anspruch 17, dadurch gekennzeichnet, daß die Potentialänderungseinrichtungen (120) so ausgebildet sind, daß sie selektiv das Potential an der zweiten Elektrode (112) des zweiten Kondensators (C0) schrittweise vom bekannten zweiten Wert (E2) in Richtung auf den ersten bekannten Wert (E1) wandern lassen.

19. Vorrichtung nach einem der Ansprüche 17 und 18, dadurch gekennzeichnet, daß die Potentialänderungseinrichtungen (120) außerdem so ausgebildet sind, daß sie wahlweise das Potential an der zweiten Elektrode (112) des zweiten Kondensators (C0) zwischen dem zweiten bekannten Wert (E2) und dem ersten bekannten Wert (E1) ändern, woraufhin das Potential an der zweiten Elektrode (112) des zweiten Kondensators (C0) schrittweise vom ersten bekannten Wert (E1) in Richtung auf den zweiten bekannten Wert (E2) wandern gelassen wird.

20. Vorrichtung nach einem der Ansprüche 17 bis 19, dadurch gekennzeichnet, daß die Vorladeeinrichtungen (S0) einen Schalter umfassen.

21. Vorrichtung nach Anspruch 20, dadurch gekennzeichnet, daß der Vorladeschalter (S0) so ausgebildet ist, daß er die zweite Elektrode (103) des ersten Kondensators (C) entweder an ein Potential gleich dem ersten bekannten Wert (E1) oder an ein Potential gleich dem zweiten bekannten Wert (E2) liegt.

22. Vorrichtung nach einem der Ansprüche 17 bis 21, dadurch gekennzeichnet, daß die Potentialkopiereinrichtungen einen Folgeoperationsverstärker (OP110) und einen Schalter (S1) umfassen.

23. Vorrichtung nach einem der Ansprüche 17 bis 22, dadurch gekennzeichnet, daß die Schalteinrichtungen einen Schalter (S2) umfassen.

24. Vorrichtung nach einem der Ansprüche 17 bis 23, dadurch gekennzeichnet, daß die Potentialänderungseinrichtungen (120) einen Digital/Analog-Wandler umfassen, der über die Folgesteuereinrichtung (140) angesteuert wird.

25. Vorrichtung nach einem der Ansprüche 17 bis 24, dadurch gekennzeichnet, daß der besagte bekannte Wert gleich dem ersten bekannten Wert und der Bezugswert gleich dem zweiten bekannten Wert ist, und die Vorrichtungen Einrichtungen umfaßt, die die Kapazität des zu messenden Kondensators (C) auf der Grundlage der Beziehung

$$(6) \qquad C \simeq C0 \, (N - 1)$$

bestimmen können, in welcher Beziehung C0 die Kapazität des Bezugskondensators bezeichnet und N die Anzahl der Wiederholungen der Schritte b) und c) bezeichnet.

26. Vorrichtung nach einem der Ansprüche 17 bis 24, dadurch gekennzeichnet, daß der besagte bekannte Wert gleich dem ersten bekannten Wert ist und der Bezugswert gleich dem zweiten bekannten Wert ist und daß die Vorrichtung Einrichtungen umfaßt, die die Kapazität des zu messenden Kondensators (C) auf der Grundlage der Beziehung

$$(12) \qquad C = C0 \, [N - 1 - P / (2^M - 1)]$$

bestimmen können, in welcher Beziehung C0 die Kapazität des Bezugskondensators bezeichnet, N die Anzahl der Wiederholungen der Schritte b) und c) ist, P die Anzahl der im Schritt e) ausgeführten Schritte ist, und $(2^M - 1)$ die Anzahl der Schritte zwischen dem ersten bekannten Wert (E1) und dem zweiten bekannten Wert (E2) ist.

27. Vorrichtung nach einem der Ansprüche 17 bis 24, dadurch gekennzeichnet, daß der besagte bekannte Wert gleich dem ersten bekannten Wert ist, und der Bezugswert gleich dem zweiten bekannten Wert ist und daß die Vorrichtung Einrichtungen umfaßt, die die Kapazität des zu messenden Kondensators auf der Grundlage der Beziehung

$$(18) \qquad C = C0 \, [(N + Q) / 2 - 1 - (P + R) / 2 \, (2^M - 1)]$$

messen können, in welcher Beziehung C0 die Kapazität des Bezugskondensators wiedergibt, N die Anzahl der Wiederholungen der Schritte b) und c) ist, Q die Anzahl der Wiederholungen der Schritte g) und h) ist, P die Anzahl der im Schritt e) ausgeführten Schritte bezeichnet, R die Anzahl der im Schritt j) ausgeführten Schritte bezeichnet, und $(2^M - 1)$ die Anzahl der Schritte zwischen dem ersten bekannten Wert (E1) und dem zweiten Wert (E2) ist.

28. Vorrichtung nach Anspruch 24 in Kombination mit einem der Ansprüche 26 und 27 dadurch gekennzeichnet, daß (M) die Anzahl der Bits des Digital/Analog-Wandlers (120) ist.

**Claims**

1. A method of measuring capacitance, the method making use of a reference capacitance (C0) in addition to the capacitance to be measured (C), the method being characterized by the fact that it comprises the following steps:

    a precharging to a known value a "first" one of two capacitances (C) having a first electrode (101) connected to ground;

    b placing a first electrode (111) of the other "second" capacitance (C0) at the same potential as the second electrode (103) of the first capacitance (C);

c connecting the first electrode (111) of the second capacitance (C0) to the second electrode (103) of the first capacitance (C) and switching the potential on the second electrode (112) of the second capacitance (C0) between a first known value (E1) and a second known value (E2); and

d comparing the potential on the second electrode (103) of the first capacitance (C) with a reference value (V2), and iterating above steps b and c so long as the potential on the second electrode (103) of the first capacitance (C) does not cross the reference value (V2), and counting the number of iterations (N), the potential on the second electrode (112) of the second capacitance (C0) being returned from the second known value (E2) to the first known value (E1) after the first electrode of the second capacitance (C0) has been separated from the second electrode (103) of the first capacitance (C), before each iteration.

2.  A method according to claim 1, characterized by the fact that step a consists in charging the first capacitance (C) to a voltage (V1) equal to said first known value (E1).

3.  A method according to claim 1 or 2, characterized in that the reference value (V2) is equal to said second known value (E2).

4.  A method according to any one of claims 1 to 3, characterized by the fact that said first known value (E1) is less than said second known value (E2).

5.  A method according to any one of claims 1 to 4, characterized by the fact that step b consists in connecting the first electrode (111) of the second capacitance (C0) to the second electrode (103) of the first capacitance via a follower amplifier (OP110) and a switch (S1).

6.  A method according to any one of claims 1 to 5, characterized by the fact that in step c, the potential on the second electrode (112) of the second capacitance (C0) is switched from the first known value (E1) to the second known value (E2) after the first electrode (111) of the second capacitance (C0) has been connected to the second electrode (103) of the first capacitance.

7.  A method according to any one of claims 1 to 5, characterized by the fact that in step c, the potential on the second electrode (112) of the second capacitance (C0) is switched from the first known value (E1) to the second known value (E2) before the first electrode (111) of the second capacitance (C0) has been connected to the second electrode (103) of the first capacitance.

8.  A method according to any one of claims 1 to 7, characterized by the fact that after step c the potential on the second electrode (112) of the second capacitance (C0) is returned from the second known value (E2) to the first known value (E1) after the first electrode (111) of the second capacitance (C0) has been separated from the second electrode (103) of the first capacitance (C).

9.  A method according to any one of claims 1 to 7, characterized by the fact that it further includes the following step:

e causing the potential on the second electrode (112) of the second capacitance (C0) to change in voltage steps from the second known value (E2) towards the first known value (E1) until the potential on the second electrode (103) of the first capacitance (C) is again detected as crossing the reference value (V2), and counting the number of voltage steps (P) performed.

10. A method according to any one of claims 1 to 9, characterized by the fact that above-mentioned steps a, b, c, d, and e are then reproduced after interchanging said first known value (E1) and said second known value (E2).

11. A method according to any one of claims 1 to 10, characterized by the fact that it comprises the following steps:

e causing the potential on the second electrode (112) of the second capacitance (C0) to change in voltage steps from the second known value (E2) towards the first known value (E1) until the potential on the second electrode (103) of the first capacitance (C) is again detected as crossing the first reference value (V2), and counting the number of voltage steps (P) performed during the course of this step e);

f precharging to a known value the first one of the capacitance (C);

g placing the first electrode (111) of the second capacitance (C0) at the same potential as the second electrode (103) of the first capacitance (C);

h connecting the first electrode (111) of the second capacitance (C0) to the second electrode (103) of the first capacitance (C) and switching the potential on the second electrode (112) of the second capacitance (C0) between the second known value (E2) and the first known value (E1); and

i comparing the potential on the second electrode (103) of the first capacitance (C) with a second reference value (V1), and iterating above steps g and h so long as the potential on the second electrode (103) of the first capacitance (C) does not cross the second reference value (V1), and counting the number of iterations (Q) of steps g and h, the potential on the second electrode (112) of the second capacitance (C0) being returned from the first known value (E1) to the second known value (E2) after the first electrode (111) of the second capacitance (C0) has been separated from the second electrode (103) of the first capacitance (C) before each iteration of steps g and h; and

j causing the potential on the second electrode (112) of the second capacitance (C0) to change in voltage steps from the first known value (E1) towards the second known value (E2) until the potential on the second electrode (103) of the first capacitance (C) is again detected as crossing the second reference value (V1), and counting the number of voltage steps (R) performed during the course of this step j).

12. A method according to claim 11, characterized by the fact that:

step a consists in charging the first capacitance (C) to a voltage (V1) equal to the first known value (E1);

step f consists in charging the first capacitance (C) to a voltage (V2) equal to the second known value (E2);

the first reference value is equal to the second known value (E2); and

the second reference value is equal to the first known value (E1).

13. A method according to any one of claims 1 to 12, characterized by the fact that the first capacitance is the capacitance to be measured (C).

14. A method according to any one of claims 1 to 8 and taken in combination with claims 2 and 3, characterized by the fact that the capacitance to be measured is determined on the basis of the equation:

$$(6) \qquad C \approx C0[N - 1]$$

in which equation:

C0 represents the reference capacitance; and

N represents the number of iterations in steps b and c.

15. A method according to any one of claims 1 to 9 and taken in combination with claims 2 and 3, characterized by the fact that the capacitance to be measured is determined on the basis of the following equation:

$$(12) \qquad C = C0[N - 1 - P/[2^M - 1]]$$

in which:

C0 represents the reference capacitance;

N represents the number of iterations in steps b and c;

P represents the number of voltage steps used in step e; and

$[2^M - 1]$ represents the number of voltage steps between the first known value (E1) and the second known value (E2).

16. A method according to claim 11 or 12 and taken in combination with claims 2 and 3, characterized by the fact that the size of the change in step j of the potential on the second electrode (112) of the second capacitance (C0) is equal to the size of the change of the same potential in step e, and the capacitance to be measured is determined on the basis of the following equation:

$$(18) \qquad C = C0[[N + Q]/2 - 1 - [P + R]/2[2^M - 1]]$$

in which

C0 represents the reference capacitance;

N represents the number of iterations of steps b and c;

Q represents the number of iterations of steps g and h;

P represents the number of voltage steps performed in step e; and

R represents the number of voltage steps performed in step j; and

$[2^M - 1]$ represents the number of voltage steps between the first known value (E1) and the second known value (E2).

17. Apparatus for implementing the method according to any one of claims 1 to 16, characterized by the fact that it comprises:

precharging means (S0) suitable for precharging to a known value (V1) a first capacitance (C) having a first electrode (101) connected to ground;

voltage copying means (OP110, S1) for placing a first electrode (111) of a second capacitance (C0) to the same potential as the second electrode (103) of the first capacitance (C);

transfer means (S2) suitable for connecting the first electrode (111) of the second capacitance (C0) to the second electrode (103) of the first capacitance (C);

potential changing means (120) suitable for switching the potential on the second electrode (112) of the second capacitance (C0) between a first known value (E1) and a second known value (E2);

comparator means (OP130) suitable for comparing the potential on the second electrode (103) of the first capacitance (C) with a reference value (E2); and

sequencer means (140) responsive to the output from the comparator means (OP130) and designed to control the potential copying means (0P110, S1), the transfer means (S2), and the potential changing means (120), and for counting the number of times they are used (N, P, Q, R).

18. Apparatus according to claim 17, characterized by the fact that the potential changing means (120) are designed to cause the potential on the second electrode (112) of the second capacitance (C0) to change in voltage steps, from the second known value (E2) towards the first known value (E1).

19. Apparatus according to claim 17 or 18, characterized by the fact that the potential changing means (120) are also designed to selectively switch the potential on the second electrode (112) of the second capacitance (C0) between the second known value (E2) and the first known value (E1), and then to cause the potential on the second electrode (112) of the second capacitance (C0) to change in voltage steps from the first known value (E1) towards the second known value (E2).

20. Apparatus according to any one of claims 17 to 19, characterized by the fact that the precharge means (S0) include a switch.

21. Apparatus according to any one of claim 20, characterized by the fact that the precharge switch (S0) is designed to connect the second electrode (103) of the first capacitance (C) either to a potential equal to the first known value (E1) or else to a potential equal to the second known value (E2).

22. Apparatus according to any one of claims 17 to 21, characterized by the fact that the potential copying means comprise a follower operational amplifier (OP110) and a switch (S1).

23. Apparatus according to any one of claims 17 to 22, characterized by the fact that the transfer means comprise a switch (S2).

24. Apparatus according to any one of claims 17 to 23, characterized by the fact that the potential changing means (120) comprise a digital-to-analog converter controlled by the sequencer means (140).

25. Apparatus according to any one of claims 17 to 24, characterized by the fact that said known value is equal to the first known value and the reference value is equal to the second known value and that it includes means for determining the capacitance to be measured (C) on the basis of the following equation:

$$(6) \qquad C \approx C0[N - 1]$$

in which equation:

C0 represents the reference capacitance; and

N represents the number of iterations in steps b and c.

26. Apparatus according to any one of claims 17 to 24, characterized by the fact that said known value is equal to the first known value and the reference value is equal to the second known value and that it includes means suitable for determining the capacitance to be measured (C) on the basis of the following equation:

$$(12) \qquad C = C0[N - 1 - P/[2^M - 1]]$$

in which:

C0 represents the reference capacitance;

N represents the number of iterations in steps b and c;

P represents the number of voltage steps used in step e; and

$[2^M - 1]$ represents the number of voltage steps between the first known value (E1) and the second known value (E2).

27. Apparatus according to any one of claims 17 to 24, characterized by the fact that said known value is equal to the first known value and the reference value is equal to the second known value and that it includes means suitable for measuring the capacitance to be measured on the basis of the following equation:

$$(18) \qquad C = C0[[N + Q]/2 - 1 - [P + R]/2[2^M - 1]]$$

in which

C0 represents the reference capacitance;

N represents the number of iterations of steps b and c;

Q represents the number of iterations of steps g and h;

P represents the number of voltage steps performed in step e; and

R represents the number of voltage steps performed in step j; and

$[2^M - 1]$ represents the number of voltage steps between the first known value (E1) and the second known value (E2).

28. Apparatus according to claim 24 taken in combination with claim 26 or claim 27, characterized by the fact that M represents the number of bits of the digital-to-analog converter (120).

# FIG_1

FERMETURE S0
TENSION VC = V1 — 200

OUVERTURE S0 — 202

FERMETURE S1
TENSION VCO=VC-E1 — 211

$VC = VC_{+1}$ — 218

OUVERTURE S1 — 212

DESCENTE SORTIE
CONVERTISSEUR 120
DE E2 à E1 — 217

FERMETURE S2 — 213

210

OUVERTURE S2 — 216

MONTEE SORTIE DU
CONVERTISSEUR 120
DE E1 à E2
NOUVELLE TENSION
$VC_{+1}$ SUR C :
$VC_{+1} = VC + \dfrac{(E2-E1)CO}{C+CO}$ — 214

NON — $VC+1 \geq V2$ — OUI

215

$VC = VC_{+1} =$
$V1 + \dfrac{N(E2-E1)}{C+CO} CO \simeq V2$
Soit
$C \simeq CO(N-1)$ — 220

FIG_2

# FIG_3

220

DESCENTE SORTIE CONVERTISSEUR DE

$$\frac{(E2-E1)\ C0}{(C+C0)\ (2^M-1)}$$

$$\overline{\text{NOUVELLE TENSION}}$$

$VC_{+1}$ sur C :

$$VC_{+1} = VC - \frac{(E2-E1)\ C0}{(C+C0)(2^M-1)}$$

230

232

$$VC = VC_{+1}$$

231

OUI

$$VC_{+1} \leqslant V2$$

NON

$$VC = VC_{+1} =$$

$$V1 + \frac{N(E2-E1)\ C0}{C+C0} - \frac{P(E2-E1)C0}{(C+C0)(2^M-1)} \simeq V2$$

soit

$$C \simeq C0\ [N-1-P/(2^M-1)]$$

233

233

240

$$V1 + \frac{N(E2-E1)C0}{C+C0} - \frac{P(E2-E1)C0}{(C+C0)(2^M-1)} = V2+V0$$

241
FERMETURE S0 ; TENSION VC = V2

242
OUVERTURE S0

250

258

251
FERMETURE S1 ; TENSION VC0 = V2-VC

VC = VC+1

OUVERTURE S1 — 252

257
MONTEE SORTIE
CONVERTISSEUR
E1 à E2

FERMETURE S2 — 253

FIG_4

DESCENTE CONVER-
TISSEUR DE E2 à E1
$$VC_{+1} = VC - \frac{(E2-E1)C0}{C+C0}$$
254

OUVERTURE S2

256

$VC_{+1} \leqslant V1$ — 255

NON

OUI

VC = VC_{+1}

256

257
MONTEE SORTIE CONVERTISSEUR
$$\frac{(E2-E1)C0}{(C+C0)(2^M-1)}$$
$$VC_{+1} = VC + \frac{(E2-E1)C0}{(C+C0)(2^M-1)}$$

OUI

$VC_{+1} \geqslant V1$ — 258

NON

259
$$V2 - \frac{Q(E2-E1)C0}{C+C0} + \frac{R(E2-E1)C0}{(C+C0)(2^M-1)} = V1+V0$$

soit

$$C = C0[\frac{(N+Q)}{2} - 1 - \frac{(P+R)}{2(2^M-1)}]$$

FIG_5

# FIG_6

PRECHARGE C

RECOPIE POTENTIEL
S1

FERMETURE S2

SORTIE CNA

TENSION SUR C

TENSION SUR
PREMIERE ELECTRODE
DE CO

TENSION SUR
SECONDE ELECTRODE
DE CO

T2N  T3N  T4N  T8        T9        T9        T9P

EP 0 509 915 B1

FIG_7